# EUROPEAN PATENT SPECIFICATION

(11) **EP 0 443 533 B1**
(45) Date of publication and mention of the grant of the patent: **30.09.1998**
(21) Application number: 91102371.1
(22) Date of filing: 19.02.1991
(51) Int. Cl.: G03F 7/022

(54) **Positive photoresist composition**
Positive arbeitende Photolackzusammensetzung
Composition pour photoréserve positive

(30) Priority: 20.02.1990 JP 39299/90
(43) Date of publication of application: 28.08.1991
(73) Proprietor: FUJI PHOTO FILM CO., LTD., Kanagawa (JP)
(72) Inventor: Kawabe, Yasumasa, c/o Fuji Photo Film Co., Ltd., Haibara-gun, Shizuoka (JP); Nishiyama, Fumiyuki, c/o Fuji Photo Film Co., Ltd., Haibara-gun, Shizuoka (JP); Tan, Shiro, c/o Fuji Photo Film Co., Ltd., Haibara-gun, Shizuoka (JP); Kuboyama, Reiko, c/o Fuji Photo Film Co., Ltd., Haibara-gun, Shizuoka (JP)
(74) Representative: Barz, Peter, Dr.

(56) References cited:
- EP-A- 275 970
- EP-A- 303 945
- DE-A- 2 944 237
- PATENT ABSTRACTS OF JAPAN vol. 13, no. 478 (P-951)(3826) 30 October 1989, & JP- A-1 189644 (FUJI PHOTO FILM CO LTD) 18 July 1989,

## Description

The present invention relates to a positive photoresist composition which is sensitive to radiation. In particular, the present invention relates to a positive photoresist composition that has excellent developability and high resolving power and sensitivity and which is especially useful for forming fine patterns with good sectional shapes. Typical technical fields to which the positive photoresist of this type is applied include, for example, manufacture of semiconductors such as IC (integrated circuits) or the like, manufacture of circuit plates for liquid crystal devices or thermal heads, and other photofabrication processes.

In general, a positive photoresist composition containing an alkali-soluble resin and a photosensitive substance of a naphthoquinonediazide compound is used. For instance, novolak type phenol resins/naphthoquinonediazide substituent compounds are described in US-A-3,666,473, 4,115,128 and 4,173,470. Examples of typical compositions, such as cresol-formaldehyde novolak resins/trihydroxybenzophenone-1,2-naphtioquinonediazide sulfonates are described in L.F. Thompson, Introduction to Microlithography (published by ACS Publishing Co., No. 219, pages 112 to 121).

Novolak resins used as a binder are soluble in an aqueous alkaline solution, do not swell therein, and are highly resistant to plasma etching when the image pattern is used as an etching mask. Therefore, they are especially advantageous for the present use. On the other hand, naphthoquinonediazide compounds to be used as a photosensitive substance act as a dissolution inhibitor to lower the alkali solubility of novolak resins but they are decomposed by light irradiation to release an alkali-soluble substance which thereby elevates the alkali solubility of novolak resins. Due to the significant light dependent variation property of these compounds, the present compounds are especially useful as a photosensitive substance component in a positive photoresist composition.

Many positive photoresists containing novolak resins and photosensitive naphthoquinonediazide substances have previously been developed and put to practical use. They provide a sufficient result in working image patterns having a line width of from about 1.5 µm to 2 µm.

Recently, integrated circuits have needed a much elevated integration degree, and ultrafine patterns composed of ultrathin lines of 1 µm or less have been needed in the manufacture of semiconductor substrates for ultra-LSI or the like. In such uses, photoresists having a high resolving power, a precise pattern shape reproducibility capable of accurately transcribing the shape of an exposure mask, a high producibility and a high sensitivity are required. Additionally, photoresists which are free from development failure have recently been in great demand. Development failure occurs when (1) the exposed area which is naturally removed by development cannot completely be removed by development and the area is slightly left on the substrate (the remaining area is hereinafter referred to as a "resist residue"), or (2) when the layer of a fine resist pattern in the nonexposed area is peeled off (the peeling is hereinafter referred to as "pattern layer peeling") and the peeled layer adheres to the exposed area.

In order to overcome development failure, a technique of adding surfactants or hydrophilic organic solvents to the developer to be applied to resists for development has been known, which is described, for example, in JP-A-58-57128, JP-A-60-158442, JP-A-60-223120, JP-A-61-167948, JP-A-62-32451, JP-A-62-32453, JP-A-49-91177, JP-A-59-182444, JP-A-60-158461, JP-A-60-241051, JP-A-61-39041, JP-A-61-259523 and JP-A-61-232453 (the term "JP-A" as used herein refers to a "published unexamined Japanese patent application") and US-A-4,374,920. However, known developers containing surfactants or hydrophilic solvents are almost ineffective for preventing resist residue and pattern layer peeling. Although somewhat effective for this purpose, most surfactants and hydrophilic solvents have drawbacks in that the reduction of the pattern layer of the nonexposed area is large, the dimensional accuracy is poor, and the cross sectional shape of the resist pattern to be formed is often trapezoidal. Therefore, the resolving power is lowered.

In order to obtain a positive photoresist having high resolving power and to form a resist pattern having a good sectional shape from the photoresist, it has been known to be effective to elevate the esterification degree of the photosensitive substance in the resist composition, as proposed, for example, in JP-A-60-42753, JP-A-60-15884Q, JP-A-63-110446, JP-A-63-115162, JP-A-63-178229, JP-A-1-142548, JP-A-1-177031, JP-A-1-179147 and JP-A-1-283556. (Esterification degree is represented by the proportion of the hydroxyl groups in the polyhydroxy compound as esterified with 1,2-naphthoquinonediazido-5-(and/or -4-)sulfonate(s) in the photosensitive substance.) In general, however, the use of photosensitive agents having a high esterification degree causes problems in that the agents often induce development failure and precipitate in the resist composition after storage for a long period of time. Methods of preventing such precipitation of photosensitive agents have been illustrated in, for example, JP-A-62-123444, JP-A-62-178562, JP-A-62-284354, JP-A-63-24244, JP-A-63-110446, JP-A-63-113451, JP-A-63-236030, JP-A-63-236031, JP-A-63-237053, JP-A-63-249143, JP-A-64-49038, JP-A-64-70746, JP-A-1-154145, JP-A-1-222255, JP-A-1-283556, JP-A-1-293340 and JP-A-1-293341. However, almost no method which is effective for overcoming development failure has been known.

JP-A-63-161449 discloses a technique for obtaining a photoresist capable of forming a resist pattern having a good cross sectional shape, and mentions that the combination of a 1,2-naphthoquinonediazidosulfonate of an aromatic hydroxy compound having one hydroxyl group in one molecule and a compound having two or more 1,2-naphthoquinonediazidosulfonyl groups in one molecule in a proportion of from 0.5/1 to 3/1 is effective for elevating the contrast and for effectively preventing halation from a highly reflective substrate. In accordance with this method, however, the resolving power and sensitivity lower, and development failure cannot be sufficiently overcome even though the cross sectional shape of the pattern resist is somewhat improved.

DE-A-2944237 discloses photosensitive compositions containing a 1,2-naphthoquinondiazido-4-sulfonate of a phenol having 1 to 5 electron-withdrawing groups and, optionally, a corresponding sulfonate ester of, e.g., phenol or cresol formaldehyde resin.

An object of the present invention is to provide a positive photoresist composition which has high resolving power and sensitivity and which can form a resist pattern having a good cross sectional shape. The present composition is useful for manufacturing semiconductor devices. Additionally, it is free from the problem of development failure and has excellent storage stability.

The present inventors earnestly studied and investigated various positive photoresist compositions with regard to the above mentioned problems and, as a result, have achieved the present invention.

Specifically, the object of the present invention has been attained by a positive photoresist composition, which contains:
(A) an alkali-soluble resin,
(B) (a) 1,2-naphthoquinonediazido-5-sulfonate(s) of an aromatic hydroxy compound having one hydroxyl group per molecule and being of formula (I) as defined below, and
(C) (a) 1,2-naphthoquinonediazido-5-sulfonate(s) of an aromatic polyhydroxy compound having four to six hydroxyl groups in one molecule,
the ratio of (B)/(C) being from 5/95 to 35/65.

The positive photoresist composition of the present invention is coated on a substrate such as a semiconductor wafer, glass, ceramic or metal in a thickness of from 0.5 to 3 µm by spin coating or roller coating. Afterwards, the coated layer is heated and dried, and a circuit pattern or the like is printed on the layer via a mask by irradiation of ultraviolet rays thereto through the mask. Then, it is developed to form a positive image on the substrate. Further, the substrate is etched, using the positive image as a mask, whereby an intended pattern is formed on the mask.

Next, the present invention will be explained in detail below.

The above 1,2-naphthoquinonediazido-5-sulfonate(s) of an aromatic hydroxy compound having one hydroxyl group per molecule are compounds of the following formula (I): 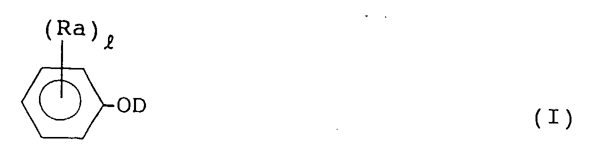 wherein Ra represents hydrogen, a halogen, a cyano group, a cycloalkyl group, an alkyl group, an aryl group, an alkenyl group or an alkoxy group; D represents a 1,2-naphthoquinonediazido-5-sulfonyl group; and ℓ represents an integer of from 1 to 5;

Specific examples of compounds of formula (I) include 1,2-naphthoquinonediazido-5-sulfonates of phenol, cresols (such as m-cresol, p-cresol or o-cresol), xylenols (such as 2,5-xylenol, 3,5-xylenol, 3,4-xylenol, 2,3-xylenol, 2,4-xylenol or 2,6-xylenol), or m-ethylphenol, p-ethylphenol, 2-ethylphenol, 3-ethylphenol, 4-ethylphenol, 2-isopropylphenol, 3-isopropylphenol, 4-isopropylphenol, 2-n-propylphenol, 3-n-propylphenol, 4-n-propylphenol, 2-tert-butylphenol, 3-tertbutylphenol, 4-tert-butylphenol, 2-sec-butylphenol, 3-sec-butylphenol, 4-sec-butylphenol, p-tert-amylphenol, p-octylphenol, 3-n-pentadecylphenol, o-chlorophenol, m-chlorophenol, p-chlorophenol, o-bromophenol, m-bromophenol, p-bromophenol, 2-iodophenol, 3-iodophenol, 4-iodophenol, 2-fluorophenol, 3-fluorophenol, 4-fluorophenol, o-methoxyphenol, m-methoxyphenol, p-methoxyphenol, 2,3-dichlorophenol, 3,5-dichlorophenol, 3,4-dichlorophenol, 2,4-dichlorophenol, 2,6-dichlorophenol, 4-bromo-2-chlorophenol, 2-chloro-4-fluorophenol, 2-bromo-4-chlorophenol, 2-chloro-6-methylphenol, 2-chloro-3-methylphenol, 2-chloro-4-methylphenol, 2-chloro-5-methylphenol, 4-chloro-2-methylphenol, 4-chloro-3-methylphenol, 4-ethyl-2-methoxyphenol, 3,5-dimethoxyphenol, 2,3-dimethoxyphenol, 2,4-dimethoxyphenol, 3,4-dimethoxyphenol, 2,6-dimethoxyphenol, 3-ethoxy-4-methoxyphenol, 3-chloro-5-methoxyphenol, 2-chloro-5-methoxyphenol, 2-ethoxyphenol, 3-ethoxyphenol, 4-ethoxyphenol, 2-isopropoxyphenol, 4-n-propoxyphenol, 4-n-butoxyphenol, 4-pentyloxyphenol, 4-hexyloxyphenol, 4-heptyloxyphenol, 4-chloro-2,3-dimethylphenol, 4-chloro-2,6-dimethylphenol, 2-chloro-4,5-dimethylphenol, 4-chloro-3,5-dimethylphenol, 4-bromo-3,5-dimethylphenol, 2,4-dichloro-6-methylphenol, 4-chloro-2,5-dimethylphenol, 2,4-dichloro-5-methylphenol, 4-bromo-2,6-dimethylphenol, 4-bromo-6-chloro-o-cresol, 2-bromo-4,5-dimethylphenol, 2,6-dibromo-4-methylphenol, α,α,α-trifluoro-p-cresol, α,α,α-trifluoro-m-cresol, α,α,α-trifluoro-o-cresol, 2,3,4-trichlorophenol, 2,3,6-trichlorophenol, 2,3,5-trichlorophenol, 4-bromo-2,6-dichlorophenol, 2,4,6-trichlorophenol, 3,4,5-trichlorophenol, 2,4,6-triiodophenol, 2,4,6-tribromophenol, 2,4-dichloro-6-iodophenol, 2-tert-butyl-5-methylphenol, 4-tert-butyl-2-methylphenol, 2-tert-butyl-6-methylphenol, 2-tert-butyl-4-methylphenol, 3-tert-butyl-5-methylphenol, 2,4-di-tert-butylphenol, 2,6-di-tert-butylphenol, 2,5-di-tert-butylphenol, 3,5-di-tert-butylphenol, 2,6-di-sec-butylphenol, 2,6-diisopropylphenol, 4-tert-butyl-2-chlorophenol, thymol, isothymol, 2,4-diisopropylphenol, 2,5-diisopropylphenol, 2,3,5-trimethylphenol, 2,4,5-trimethylphenol, 3,4,5-trimethylphenol, 3,4,5-trimethoxyphenol, 2,4,6-trimethylphenol, 2,3,6-trimethylphenol, 4-chloro-2,3,6-trimethylphenol, 4-chloro-2,3,5-trimethylphenol, 2,6-di-tert-butyl-4-methylphenol, 2,6-di-tert-butyl-4-ethylphenol, 2-allyl-6-methylphenol, 2,4,6-tri-tert-butylphenol, 5,6-dimethoxy-m-cresol, 2-allyl-4-methylphenol, 4-allyl-2-methoxyphenol, 2-allylphenol, o-propenylphenol, 4-allyl-2,6-dimethoxyphenol, 2-phenylphenol, 3-phenylphenol, 4-phenylphenol, 2-chloro-6-phenylphenol, 2-chloro-4-phenylphenol, 2-cyclohexylphenol, 3-cyclohexylphenol, 4-cyclohexylphenol, 4-cyclopentylphenol, p-cyanophenol, o-cyanophenol and m-cyanophenol.

One or more of such photosensitive substances of naphthoquinonediazides of aromatic hydroxy compounds having one hydroxyl group in one molecule (hereinafter referred to as "monofunctional photosensitive substances") are combined with one or more photosensitive substances of naphthoquinonediazides of aromatic polyhydroxy compounds having 4 to 6 hydroxyl groups in one molecule (hereinafter referred to as "tetrafunctional to hexafunctional photosensitive substances") in a specifically determined ratio, to give the positive photoresist composition of the present invention. The compounds as illustrated herein are by way of example.

Some of these photosensitive substances are described, for example, in JP-B-45-27345, JP-B-46-21247, JP-B-44-24323, JP-B-46-42448 and JP-B-46-42446 (the term "JP-B" as used herein refers to an "examined Japanese patent publication"), JP-A-62-191848, JP-A-62-280844, JP-A-62-280845, JP-A-63-161449 and JP-A-1-104037, U.S. Patents 3,046,113 and 2,958,599, GB-A-1,073,098 and 1,335,517, and DE-A-2,329,208 and 2,208,699.

As examples of aromatic polyhydroxy compounds having four to six hydroxyl groups in one molecule, which are employed in the present invention, there are mentioned polyhydroxybenzophenones such as 2,3,4,4'-tetrahydrobenzophenone, 2,2',4,4'-tetrahydroxybenzophenone, 2,4,6,3',4'-pentahydroxybenzophenone, 2,3,4,2',5'-pentahydroxybenzophenone, 2,4,6,3',4',5'-hexahydroxybenzophenone and 2,3,4,3',4',5'-hexahydroxybenzophenone; bis[(poly)hydroxyphenyl]alkanes such as bis(2,4-dihydroxyphenyl)methane, bis(2,3,4-trihydroxyphenyl)methane, bis(2,4-dihydroxyphenyl)propane-1, bis-(2,3,4-trihydroxyphenyl)propane-1, 1,1-(5,5'-diacetyl-2,3,4,2',3',4'-hexahydroxy)diphenylethane, 2,2-(2,3,4,2',3',4' hexahydroxy)diphenylpropane, 5,5'-diacetyl-2,3,4,2',3',4'-hexahydroxydiphenylmethane and nordihydroguaiaretic acid; polyhydroxybiphenyls such as 3,5,3',5'-biphenyltetrol, 2,4,2',4'-biphenyltetrol, 2,4,6,3',5'-biphenylpentol and 2,4,6,2',4',6'-biphenylhexol; bis-(polyhydroxy) sulfides such as 4,4'-thiobis(1,3-dihydroxy)benzene; bis(polyhydroxyphenyl) ethers such as 2,2',4,4'-tetrahydroxydiphenyl ether; bis(polyhydroxyphenyl) sulfoxides such as 2,2',4,4'-tetrahydroxydiphenyl sulfoxide; bis(polyhydroxyphenyl) sulfones such as 2,2',4,4'-tetrahydroxydiphenyl sulfone; polyhydroxytriphenylmethanes such as 4,4',3",4"-tetrahydroxy-3,5,3',5'-tetramethyltriphenylmethane, 4,4',2",3",4"-pentahydroxy-3,5,3',5'-tetramethyltriphenylmethane, 2,3,4,2',3',4'-hexahydroxy-5,5'-diacetyltriphenylmethane, and 2,4,6,2',4',6'-hexahydroxy-5,5'-dipropionyltriphenylmethane; polyhydroxyspirobi-indanes such as 3,3,3',3'-tetramethyl-1,1'-spirobi-indane-5,6,5',6'-tetrol, 3,3,3',3'-tetramethyl-1,1'-spirobi-indane-5,6,7,5',6',7'-hexol, 3,3,3',3'-tetramethyl-1,1'-spirobiindane-4,5,6,4',5',6'-hexol and 3,3,3',3'-tetramethyl-1,1'-spirobi-indane-4,5,6,5',6',7'-hexol; polyhydroxyphthalides such as 3,3-bis(3,4-dihydroxyphenyl)phthalide, 3,3-bis(2,3,4-trihydroxyphenyl)phthalide and 3',4',5',6'-tetrahydroxyspiro[phthalide-3,9'-xanthene]; polyhydroxybenzopyranes such as 2-(3,4-dihydroxyphenyl)-3,5,7-trihydroxybenzopyrane and 2-(3,4,5-trihydroxyphenyl)-3,5,7-trihydroxybenzopyrane; (polyhydroxy)benzoylpyridines such as 2-(2,3,4-trihydroxybenzoyl)-6-trihydroxypyridine, 2-(2,3,4-trihydroxybenzoyl)-5-hydroxypyridine, 2-(2,3,4-trihydroxybenzoyl)-4-hydroxypyridine, 2-(2,3,4-trihydroxybenzoyl)-3-hydroxypyridine, 3-(2,3,4-trihydroxybenzoyl)-6-hydroxypyridine, 3-(2,3,4-trihydroxybenozyl)-5-hydroxypyridine, 3-(2,3,4-trihydroxybenzoyl)-4-hydroxypyridine, 3-(2,3,4-trihydroxybenzoyl)-2-hydroxypyridine, 4-(2,3,4-trihydroxybenzoyl)-2-hydroxypyridine, 4-(2,3,4-trihydroxybenzoyl)-3-hydroxypyridine, 2-(2,4,5-trihydroxybenzoyl)-6-hydroxypyridine, 2-(2,4,5-trihydroxybenzoyl)-5-hydroxypyridine, 2-(2,4,5-trihydroxybenzoyl)-4-hydroxypyridine, 2-(2,4,5-trihydroxybenzoyl)-3-hydroxypyridine, 3-(2,4,5-trihydroxybenzoyl)-6-hydroxypyridine, 3-(2,4,5-trihydroxybenzoyl)-5-hydroxypyridine, 3-(2,4,5-trihydroxybenzoyl)-4-hydroxypyridine, 3-(2,4,5-trihydroxybenzoyl)-2-hydroxypyridine, 4-(2,4,5-trihydroxybenzoyl)-2-hydroxypyridine, 4-(2,4,5-trihydroxybenzoyl)-3-hydroxypyridine, 2-(2,4,6-trihydroxybenzoyl)-6-hydroxypyridine, 2-(2,4,6-trihydroxybenzoyl)-5-hydroxypyridine, 2-(2,4,6-trihydroxybenzoyl)-4-hydroxypyridine, 2-(2,4,6-trihydroxybenzoyl)-3-hydroxypyridine, 3-(2,4,6-trihydroxybenzoyl)-6-hydroxypyridine, 3-(2,4,6-trihydroxybenzoyl)-5-hydroxypyridine, 3-(2,4,6-trihydroxybenzoyl)-4-hydroxypyridine, 3-(2,4,6-trihydroxybenzoyl)-2-hydroxypyridine, 4-(2,4,6-trihydroxybenzoyl)-2-hydroxypyridine, 4-(2,4,6-trihydroxybenzoyl)-3-hydroxypyridine, 4-(2,4-dihydroxybenzoyl)-2,6-dihydroxypyridine, 4-(3,5-dihydroxybenzoyl)-2,6-dihydroxypyridine, 4-(2,3,4-trihydroxybenzoyl)-2,6-dihydroxypyridine, 4-(2,4,5-trihydroxybenzoyl)-2,6-dihydroxypyridine, and 4-(2,4,6-trihydroxybenzoyl)-2,6-dihydroxypyridine; (polyhydroxy)indanes such as 1-(3,4-dihydroxyphenyl)-1,3,3-trimethyl-5,6-dihydroxyindane, 1-(2,3-dihydroxyphenyl)-1,3,3-trimethyl-4,5-dihydroxyindane, 1-(2,3-dihydroxyphenyl)-1,3,3-trimethyl-6,7-dihydroxyindane, 1-(2,4-dihydroxyphenyl)-1,3,3-trimethyl-4,6-dihydroxyindane, l-(2,4-dihydroxyphenyl)-1,3,3-trimethyl-5,7-dihydroxyindane, 1-(3,5-dihydroxyphenyl)-1,3,3-trimethyl-4,6-dihydroxyindane, 1-(2,3,4-trihydroxyphenyl)-1,3,3-trimethyl-4,5,6-trihydroxyindane, 1-(2,3,4-trihydroxyphenyl)-1,3,3-trimethyl-5,6,7-trihydroxyindane, 1-(2,4,5-trihydroxyphenyl)-1,3,3-trimethyl-4,6,7-trihydroxyindane, 1-(2,4,5-trihydroxyphenyl)-1,3,3-trimethyl-4,5,7-trihydroxyindane, 1-(2,4,6-trihydroxyphenyl)-1,3,3-trimethyl-4,5,6-trihydroxyindane, 1-(2,3,4-trihydroxyphenyl)-1,3,3-triethyl-4,5,6-trihydroxyindane, 1-(2,3,4-trihydroxyphenyl)-1,3,3-triethyl-5,6,7-trihydroxyindane, 1-(3-methyl-4-hydroxyphenyl)-1,3,3-trimethyl-5,6,7-trihydroxyindane, 1-(2,4-dihydroxyphenyl)-1,3,3-trimethyl-4,6-dihydroxyindane, and 1-(2,4-dihydroxyphenyl)-1,3,3-trimethyl-5,7-dihydroxyindane; and flavonoid dyes such as morin or quercetin The tetrafunctional to hexafunctional photosensitive substances for use in the present invention are 1,2-naphthoquinonediazido-5-sulfonates of the above aromatic polyhydroxy compounds.

The composition of the present invention contains the above mentioned tetrafunctional or higher polyfunctional photosensitive substances singly or in combination of two or more. However, the illustrated polyfunctional photosensitive substances are not limitative. It is preferred that the proportion of the monofunctional photosensitive substance(s) and the tetrafunctional to hexafunctional photosensitive substance(s) in the composition of the present invention is from 10/90 to 30/70.

If the content of the monofunctional photosensitive substance(s) in the composition is less than 5% by weight, the effect of the present invention of overcoming development failure and enhancing storage stability would be unsatisfactory. Further, if it is more than 35% by weight, the resolving power and the sensitivity of the composition would lower.

The monofunctional photosensitive substances and tetrafunctional to hexafunctional photosensitive substances for use in the present invention are obtained, for example, by esterifying a part or all of the hydroxyl groups of the above mentioned (poly)hydroxy compounds with (a) 1,2-naphthoquinonediazido-5-sulfonyl chloride in the presence of a basic catalyst by conventional esterification. Specifically, a determined amount of a (poly)hydroxy compound is put in a flask along with (a) 1,2-naphthoquinonediazido-5-sulfonyl chloride and a solvent such as dioxane, acetone, methyl ethyl ketone or N-methylpyrrolidone, and the reactants are condensed with dropwise addition of a basic catalyst, such as sodium hydroxide, sodium carbonate, sodium hydrogencarbonate or triethylamine, thereto. The product obtained by such esterification is washed with water, purified and dried.

In esterification for preparing tetrafunctional to hexafunctional photosensitive substances, a mixture of various substances each having a different esterification degree at different esterified positions is obtained. Accordingly, the esterification degree as referred to herein means the average esterification degree of the mixture.

The esterification degree to be defined as above can be controlled in accordance with the mixing proportion of the starting materials of polyhydroxy compounds and 1,2-naphthoquinonediazido-5-sulfonyl chloride. Since substantially all the 1,2-naphthoquinonediazido-5-sulfonyl chloride added to the esterification system is consumed for esterifying the polyhydroxy compounds, the molar ratio of the starting materials is to be adjusted for the purpose of obtaining an ester mixture having a desired esterification degree.

The reaction temperature for the esterification step is generally from -20°C to 60°C, preferably from 0°C to 40°C.

In preparing a resin composition containing the above mentioned photosensitive substances of the present invention which are prepared by the methods mentioned above, at least one monofunctional photosensitive substance and at least one tetrafunctional to hexafunctional photosensitive substance are combined with an alkali-soluble resin, whereupon the content of the mixture of the photosensitive substances is from 5 to 100 parts by weight, preferably from 10 to 50 parts by weight, per 100 parts by weight of alkali-soluble resin. If the content of the mixture is less than 5 parts by weight, the film retentiveness would be noticeably lower. However, if it is more than 100 parts by weight, the sensitivity and the solubility in solvent would lower.

Examples of alkali-soluble resins to be used in the present invention are novolak resins, acetone-pyrogallol resins, polyhydroxystyrenes and their derivatives.

Especially preferred are novolak resins, which are obtained by reacting a monomer of a component and an aldehyde compound in the presence of an acid catalyst by addition condensation.

As the monomers to be used for obtaining novolak resins for use in the present invention, there are mentioned, for example, phenol, cresols such as m-cresol, p-cresol or o-cresol; xylenols such as 2,5-xylenol, 3,5-xylenol, 3,4-xylenol or 2,3-xylenol; alkylphenols such as m-ethylphenol, p-ethylphenol, 0-ethylphenol or p-t-butylphenol; alkoxyphenols such as p-methoxyphenol, m-methoxyphenol, 3,5-dimethoxyphenol, 2-methoxy-4-methylphenol, m-ethoxyphenol, p-ethoxyphenol, m-propoxyphenol, p-propoxyphenol, m-butoxyphenol or p-butoxyphenol; bisalkylphenols such as 2-methyl-4-isopropylphenol; and hydroxy-aromatic compounds such as m-chlorophenol, p-chlorophenol, o-chlorophenol, dihydroxybiphenyl, bisphenol A, phenylphenol, resorcinol or naphthol. These can be used singly or in combination of two or more.

The aldehyde compounds include, for example, formaldehyde, paraformaldehyde, acetaldehyde, propylaldehyde, benzaldehyde, phenylacetaldehyde, α-phenylpropionaldehyde, β-phenylpropionaldehyde, o-hydroxybenzaldehyde, m-hydroxybenzaldehyde, p-hydroxybenzaldehyde, o-chlorobenzaldehyde, m-chlorobenzaldehyde, p-chlorobenzaldehyde, o-nitrobenzaldehyde, m-nitrobenzaldehyde, p-nitrobenzaldehyde, o-methylbenzaldehyde, m-methylbenzaldehyde, p-methylbenzaldehyde, p-ethylbenzaldehyde, p-n-butylbenzaldehyde, furfural, chloroacetaldehyde and acetal derivatives of the said compounds, such as chloroacetaldehyde diethylacetal. Above all, formaldehyde is preferred.

These aldehydes may be used singly or in combination of two or more.

As the acid catalyst, for example, hydrochloric acid, sulfuric acid, formic acid, acetic acid or oxalic acid can be used.

Novolak resins for use in the present invention, which are obtained as mentioned above, preferably have a weight average molecular weight of from 2,000 to 30,000. If the molecular weight is less than 2,000, the reduction of the film of the nonexposed area after development would be too large. On the contrary, if it is more than 30,000, the development rate would be low. The molecular weight is especially preferably from 6,000 to 20,000.

The weight average molecular weight of the resins as referred to herein is defined on the basis of the molecular weight of polystyrene to be determined by gel permeation chromatography.

The composition of the present invention can contain a polyhydroxy compound, for the purpose of enhancing the dissolution of the composition with a developer, if desired. Preferred polyhydroxy compounds for this purpose include, for example, phenols, resorcinol, phloroglucinol, 2,3,4-trihydroxybenzophenone, 2,3,4,4'-tetrahydroxybenzophenone, 2,3,4,3',4',5'-hexahydroxybenzophenone, acetone-pyrogallol condensate resin and phloroglucide.

The content of the polyhydroxy compound, if any, in the composition of the present invention may be generally 100 parts by weight or less, preferably from 5 to 50 parts by weight, per 100 parts by weight of the quinonediazido compounds.

Examples of solvents for dissolving the photosensitive substances and alkali-soluble novolak resins of the composition of the present invention are ketones such as methyl ethyl ketone or cyclohexanone; keto ethers such as 4-ethoxy-2-butanone or 4-methoxy-4-methyl-2-pentanone; alcohol ethers such as ethylene glycol monomethyl ether or ethylene glycol monoethyl ether; ethers such as dioxane or ethylene glycol dimethyl ether; cellosolve esters such as methyl cellosolve acetate or ethyl cellosolve acetate; fatty acid esters such as butyl acetate, methyl lactate or ethyl lactate; halogenated hydrocarbons such as 1,1,2-trichloroethylene; and highly polar solvents such as dimethylacetamide, N-methylpyrrolidone, dimethylformamide or dimethyl sulfoxide. These solvents can be used singly or in combination of two or more.

The positive photoresist composition of the present invention can contain a surfactant for the purpose of further improving the coatability thereof and for preventing striation.

Surfactants suitable for this purpose include, for example, nonionic surfactants, such as polyoxyethylene alkyl ethers, e.g., polyoxyethylene lauryl ether, polyoxyethylene stearyl ether, polyoxyethylene cetyl ether or polyoxyethylene oleyl ether, polyoxyethylene alkylaryl ethers, e.g., polyoxyethylene octylphenol ether or polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate or sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate or polyoxyethylene sorbitan tristearate; fluorine surfactants, such as F TOP EF301, EF303 and EF352 (products by Shin-Akita Chemical Co.), Megafac® F171 and F173 (products by Dai-Nippon Ink Co.), Fluorad® FC430 and FC431 (products by Sumitomo MMM Co.), and Asahi Guard® AG710, Surflon® S-382, SC101, SC102, SC103, SC104, SC105 and SC106 (products by Asahi Glass Co.); as well as Organosiloxane Polymer KP341 (product by Shin-Etsu Chemical Co.) and acrylic acid or methacrylic acid (co)polymerized Polyflow® No. 75 and No. 95 (products by Kyoei-sha Fats and Oils Chemical Co.).

The amount of the surfactant in the composition of the present invention may be generally 2 parts by weight or less, preferably 1 part by weight or less, to 100 parts by weight of the alkali-soluble resin and quinonediazido compounds in the composition.

These surfactants may be added to the composition singly or as a combination of two or more.

As a developer for developing the positive photoresist composition of the present invention, an aqueous solution of an alkali substance can be used. Examples of alkali substances in the developer include inorganic alkalis such as sodium hydroxide, potassium hydroxide, sodium carbonate, sodium silicate, sodium metasilicate or aqueous ammonia; primary amines such as ethylamine or n-propylamine; secondary amines such as diethylamine or di-n-butylamine; tertiary amines such as triethylamine or methyldiethylamine; alcohol amines such as diethylethanolamine or triethanolamine; quaternary ammonium salts such as tetramethylammonium hydroxide or tetraethylammonium hydroxide; and cyclic amines such as pyrrole or piperidine. Further, the aqueous alkali solution may contain an appropriate amount of alcohols and/or surfactants.

If desired, the positive photoresist composition of the present invention can contain a dye, plasticizer and adhesive aid.

As examples of such additives, there are mentioned dyes such as methyl violet, crystal violet and malachite green; plasticizers such as stearic acid, acetal resins, phenoxy resins and alkyd resins; and adhesive aids such as hexamethyldisilazane and chloromethylsilane.

The positive photoresist composition of the present invention is coated on a substrate for use in preparing precision integrated circuit elements (for example, silicon/silicon dioxide coated substrate) by means of suitable coating methods using a spinner or coater. The thus coated substrate is exposed through a predetermined mask and then developed to give a good resist.

The positive photoresist composition of the present invention has a high resolving power and a high sensitivity to give a resist image having an excellent cross sectional shape. It is free from the development failures of "resist residue" and "pattern layer peeling". The composition may be dissolved in a conventional solvent to give a positive photoresist solution having excellent long term storage stability.

Next, the present invention will be explained in more detail by way of the following examples. Unless otherwise specifically defined, "%" is by weight.

### SYNTHESIS EXAMPLES

### (1) Synthesis of Photosensitive Substance (a):

14.1 g of phenol, 40.3 g of 1,2-naphthoquinonediazido-5-sulfonyl chloride and 300 ml of acetone were put in a three-neck flask and dissolved uniformly. Next, a mixture of triethylamine/acetone (15.9 g/50 ml) was gradually and dropwise added thereto and reacted at 25°C for 3 hours. Then, the reaction mixture was poured into 1,500 ml of an aqueous 1% hydrochloric acid solution, whereupon the precipitate formed was taken out by filtration, washed with water and dried at 40°C to obtain 42.4 g of phenol 1,2-naphthoquinonediazido-5-sulfonate.

### (2) Synthesis of Photosensitive Substance (b):

16.2 g of m-cresol, 40.3 g of 1,2-naphthoquinonediazido-5-sulfonyl chloride and 300 ml of acetone were put in a three-neck flask and dissolved uniformly. Next, a mixture of triethylamine/acetone (15.9 g/50 ml) was gradually and dropwise added thereto and reacted at 25°C for 3 hours. Then, the reaction mixture was poured into 1,500 ml of an aqueous 1% hydrochloric acid solution, whereupon the precipitate formed was taken out by filtration, washed with water and dried at 40°C to obtain 38.4 g of m-cresol 1,2-naphthoquinonediazido-5-sulfonate.

### (3) Synthesis of Photosensitive Substances (c) to (m):

The monofunctional photosensitive substances shown in Table 1 below were synthesized in the same manner as that of preparing Photosensitive Substance (a) mentioned above.

**TABLE 1**

| Monofunctional Photosensitive Substances Photosensitive Substances (I) | |
|---|---|
| c: | 2,4-Xylenol 1,2-naphthoquinonediazido-5-sulfonate |
| d: | 2,6-Xylenol 1,2-naphthoquinonediazido-5-sulfonate |
| e: | p-Ethylphenol 1,2-naphthoquinonediazido-5-sulfonate |
| f: | 4-Isopropylphenol 1,2-naphthoquinonediazido-5-sulfonate |
| g: | 4-tert-Butylphenol 1,2-naphthoquinonediazido-5-sulfonate |
| h: | 2,4-Dimethoxyphenol 1,2-naphthoquinonediazido-5-sulfonate |
| i: | 2-Ethoxyphenol,1,2-naphthoquinonediazido-5-sulfonate |
| j: | 2,4,6-Trimethylphenol 1,2-naphthoquinonediazido-5-sulfonate |
| k: | 4-Phenylphenol 1,2-naphthoquinonediazido-5-sulfonate |
| ℓ: | 2-Cyclohexylphenol 1,2-naphthoquinonediazido-5-sulfonate |

### (4) Synthesis of Photosensitive Substance (A):

12.3 g of 2,3,4,4'-tetrahydroxybenzophenone, 40.3 g of 1,2-naphthoquinonediazido-5-sulfonyl chloride and 300 ml of acetone were put in a three-neck flask and uniformly dissolved. Next, a mixture of triethylamine/ acetone (15.2 g/50 ml) was gradually and dropwise added thereto and reacted at 25°C for 3 hours. The reaction mixture was then poured into 1,500 ml of an aqueous 1% hydrochloric acid solution, whereupon the precipitate formed was taken out by filtration, washed with water and dried at 40°C to obtain 39.7 g of 2,3,4,4'-tetrahydroxybenzophenone 1,2-naphthoquinonediazido-5-sulfonate.

### (5) Synthesis of Photosensitive Substance (B):

42 g of pyrogallol, 33 g of acetone, 80 ml of acetic acid and 64 ml of concentrated hydrochloric acid were put in a three-neck flask and uniformly dissolved with stirring. Then, the resulting solution was heated with a water bath and refluxed for 24 hours and thereafter cooled to room temperature. After cooling, the reaction solution was dropwise added to 2,000 ml of a distilled water, whereupon the product precipitated was taken out by filtration under reduced pressure and dried. 4 g of the thus obtained 3,3,3',3'-tetramethyl-1,1'-spirobi-indane-5,6,7,5',6',7'-hexol, 13 g of 1,2-naphthoquinonediazido-5-sulfonyl chloride and 300 ml of acetone were put in a three-neck flask and uniformly dissolved with stirring. Next, a mixture of triethylamine/acetone (4.9 g/30 ml) was gradually and dropwise added thereto and reacted at room temperature for 3 hours. After reaction, the reaction mixture was dropwise added to an aqueous 1% hydrochloric acid solution, whereupon the precipitate formed was taken out by filtration and dried under reduced pressure to obtain a photosensitive substance (B).

### (6) Synthesis of Photosensitive Substance (C):

10 g of 2,4,6,3',5-biphenylpentol (phloroglucide), 40.2 g of 1,2-naphthoquinonediazido-5-sulfonyl chloride and 500 ml of acetone were put in a three-neck flask and dissolved uniformly. Next, a mixture of triethylamine/acetone (15.2 g/50 ml) was gradually and dropwise added thereto and reacted at 25°C for 3 hours. The reaction mixture was then poured into 2,500 ml of an aqueous 1% hydrochloric acid solution, whereupon the precipitate formed was taken out by filtration, washed with water and dried at 40°C to obtain 38.7 g of 2,4,6,3',5'-biphenylpentol (phloroglucide) 1,2-naphthoquinonediazido-5-sulfonate.

### (7) Synthesis of Photosensitive Substances (D) to (P):

Tetrafunctional to hexafunctional photosensitive substances as shown in Table 2 below were prepared in the same manner as that of synthesizing the above mentioned photosensitive substances (A) to (C).

**TABLE 2**

| Tetrafunctional to Hexafunctional Photosensitive Substances | | |
|---|---|---|
| Code | Photosensitive Substances (II) | Esterification Degree |
| | | (%) |
| D | 2,2',4,4'-Biphenyltetrol 1,2-naphthoquinonediazido-5-sulfonate | 68 |
| E | 2,3,4,3',4',5'-Hexahydroxybenzophenone 1,2-naphthoquinonediazido-5-sulfonate | 92 |
| F | Bis(2,4-dihydroxyphenyl)methane 1,2-naphthoquinonediazido-5-sulfonate | 84 |
| G | Nordihydroguaiaretic acid 1,2-naphthoquinonediazido-5-sulfonate | 79 |
| H | 1,1-(5,5'-Diacetyl-2,3,4,2',3',4'-hexahydroxy)diphenylethane 1,2-naphthoquinonediazido-5-sulfonate | 67 |
| I | 2,2',4,4'-Tetrahydroxydiphenyl ether 1,2-naphthoquinonediazido-5-sulfonate | 81 |
| J | 2,2',4,4'-Tetrahydroxydiphenylsulfone 1,2-naphthoquinonediazido-5-sulfonate | 77 |
| K | 4,4',3",4"-Tetrahydroxy-3,5,3',5'-tetramethyltriphenylmethane 1,2-naphthoquinonediazido-5-sulfonate | 52 |
| L | 2-(3,4-Dihydroxyphenyl)-3,5,7-trihydroxybenzopyran 1,2-naphthoquinonediazido-5-sulfonate | 81 |
| M | 4-(2,4,6-Trihydroxybenzoyl)-2,6-dihydroxypyridine 1,2-naphthoquinonediazido-5-sulfonate | 74 |
| N | 1-(3,4-Dihydroxyphenyl)-1,3,3-trimethyl-5,6-dihydroxyindane 1,2-naphthoquinonediazido-5-sulfonate | 79 |
| O | Quercetin 1,2-naphthoquinonediazido-5-sulfonate | 70 |

### (8) Synthesis of Novolak Resin (a):

45. g of m-cresol, 55 g of p-cresol, 54.0 g of aqueous 37% formalin solution and 0.05 g of oxalic acid were placed in a three-neck flask, heated to 100°C with stirring and reacted for 7 hours under the condition. After reaction, the reaction mixture was cooled to room temperature and the inner pressure was reduced to 30 mm Hg. Next, the reaction system was gradually elevated to 150°C so as to remove water and the non-reacted monomers therefrom. The novolak resin (a) thus obtained had a mean molecular weight of 8,300 (as polystyrene).

### (9) Synthesis of Novolak Resin (b):

40 g of m-cresol, 60 g of p-cresol, 49 g of aqueous 37% formalin solution and 0.13 g of oxalic acid were placed in a flask, heated to 100°C with stirring and reacted for 15 hours under the condition.

Afterwards, the temperature of the reaction system was elevated to 200°C and the inner pressure was gradually reduced to 5 mm Hg, whereupon water, the non-reacted monomers, formaldehyde and oxalic acid were removed. Next, the molten alkali-soluble novolak resin was cooled to room temperature and recovered. The thus obtained novolak resin had a weight average molecular weight of 7,100 (as polystyrene).

### (10) Preparation of Positive Photoresist Compositions and Evaluation Thereof:

1.25 g (as total weight of photosensitive substances) of one of photosensitive substances (a) to (m) and one of photosensitive substances (A) to (P) obtained in the above mentioned (1) to (3) and (4) to (7) and 5.0 g of one of cresol-novolak resins obtained in the above mentioned (8) and (9) were dissolved in ethyl cellosolve, as indicated in Table 3 below. The resulting blend was filtered through a 0.2 µm microfilter. The thus obtained photoresist composition was then coated on a silicon wafer with a spinner and dried in a convection current oven having a nitrogen atmosphere, at 90°C for 30 minutes to form a resist film having a thickness of 1.2 µm. Next, the film was exposed by the use of a reduction projection exposure device (FPA-1550, manufactured by Canon) through a test chart mask, then developed with an aqueous 2.38% tetramethylammonium hydroxide solution for 1 minute, and thereafter rinsed in water for 30 seconds and dried.

The resist pattern thus formed on the silicon wafer was observed with a scanning microscope and evaluated. The results obtained are shown in Table 3 below.

The sensitivity was defined to be the reciprocal of the exposure amount to reproduce a mask pattern of 0.70 µm, and it was represented as a relative value to the sensitivity value of the control sample of Comparative Example 1.

The film retentiveness was represented by the percentage of the ratio of the nonexposed part before development to that after development.

The resolving power means the critical resolving power for the exposure amount of reproducing a mask pattern of 0.70 µm.

The shape of the resist was represented by the angle (8) to be formed by the surface of the resist wall and the plane surface of the silicon wafer, for a cross section of a resist pattern of 0.70 µm.

Regarding "resist residue" and "pattern layer peeling", the mark "o" means that neither resist residue nor pattern layer peeling occurred and the resist pattern formed was good; the mark "×" means that both resist residue and pattern layer peeling occurred noticeably; and the mark "△" means that the both occurred slightly.

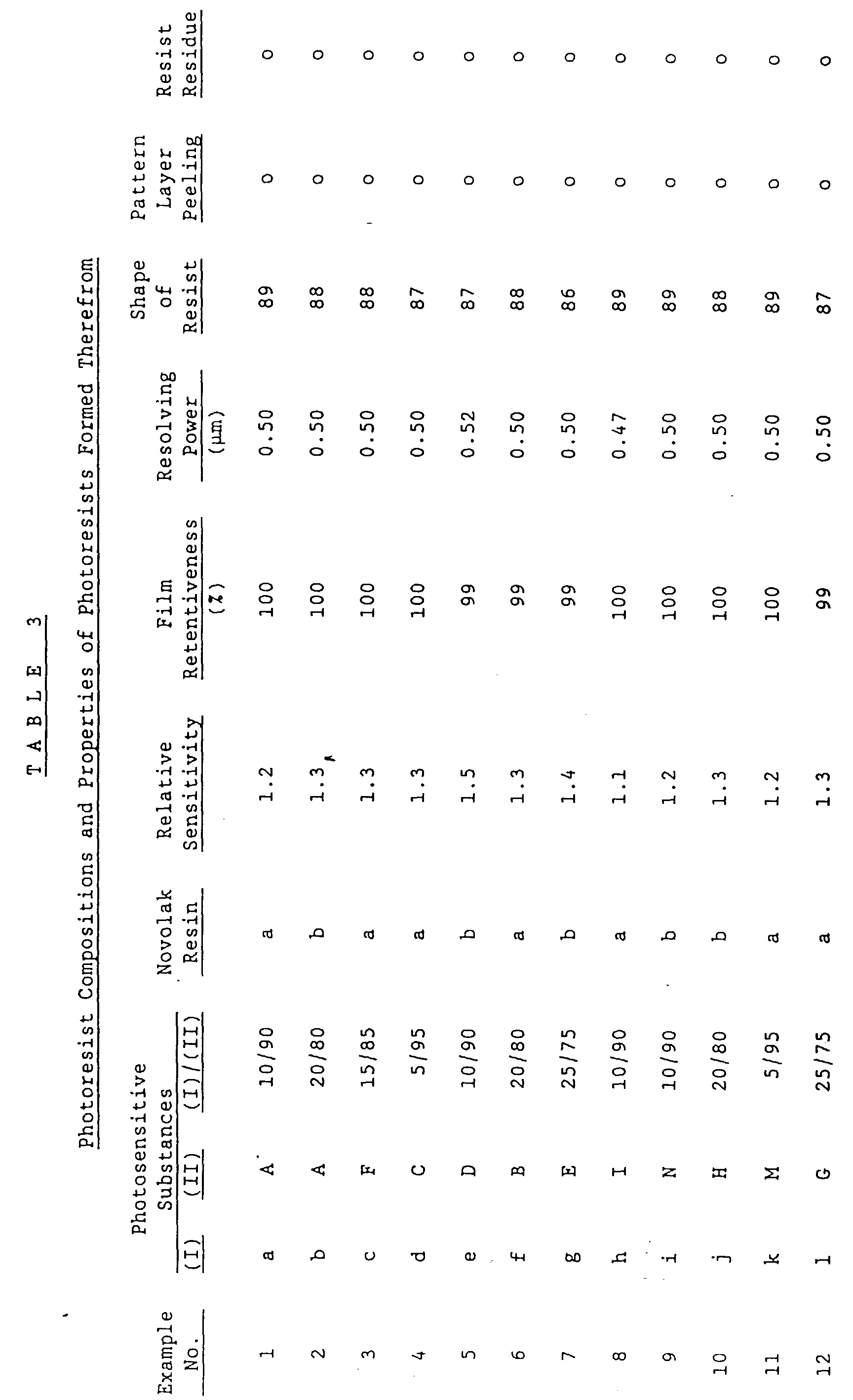

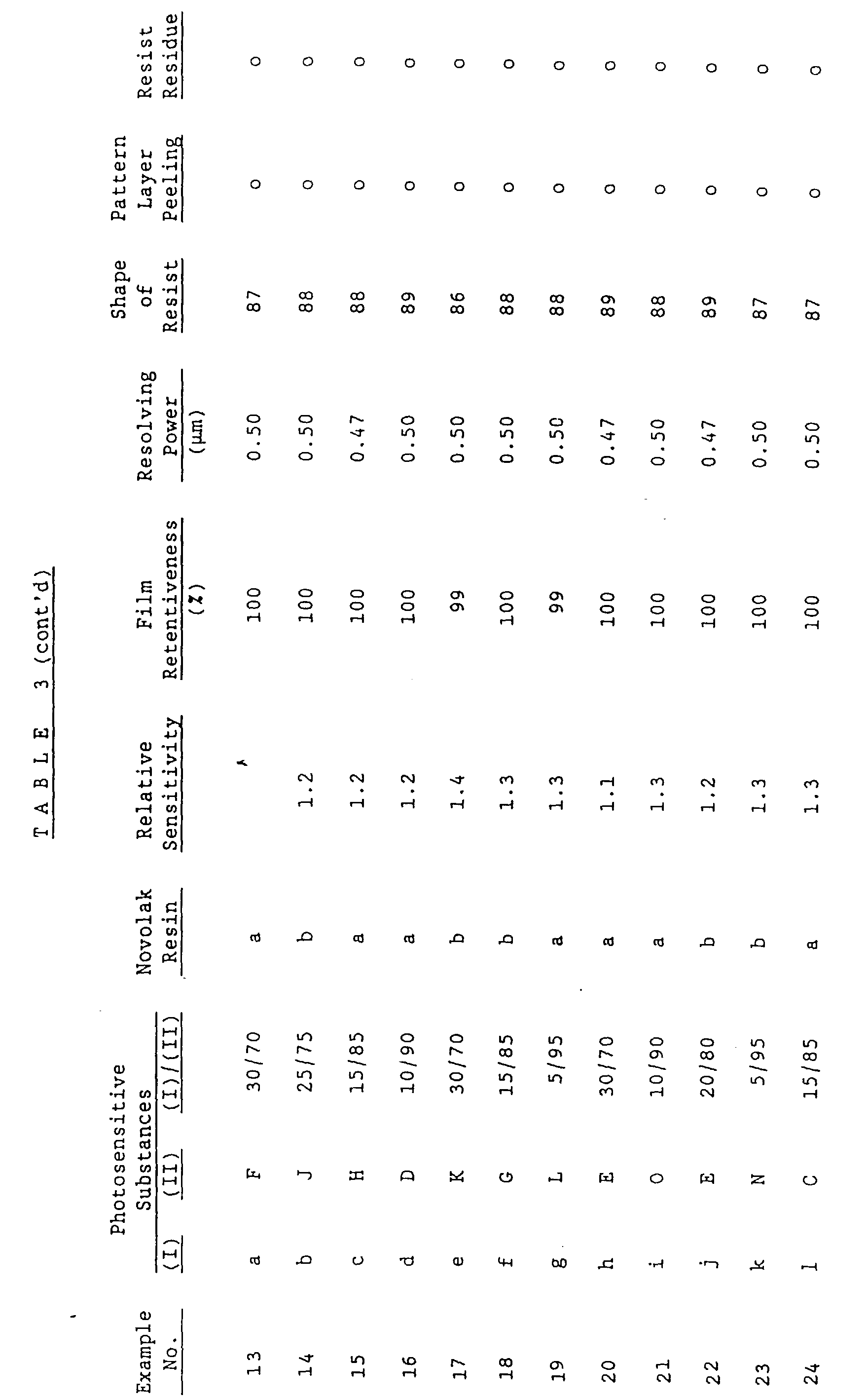

### COMPARATIVE EXAMPLES

### (1) Synthesis of Photosensitive Substances (n) to (s):

Photosensitive substances as shown in Table 4 below were prepared in the same manner as in preparation of Photosensitive Substances (A) to (C) mentioned above.

**TABLE 4**

| Photosensitive Substances | | |
|---|---|---|
| Code | Photosensitive Substances | Esterification Degree |
| | | (%) |
| n | 2,3,4-Trihydroxybenzophenone 1,2-naphthoquinonediazido-5-sulfonate | 97 |
| o | 2,4,4'-Trihydroxybenzophenone 1,2-naphthoquinonediazido-5-sulfonate | 90 |
| p | 2,4-Dihydroxybenzophenone 1,2-naphthoquinonediazido-5-sulfonate | 92 |
| q | 2,3,4-Trihydroxybenzophenone 1,2-naphthoquinonediazido-5-sulfonate | 75 |
| r | Phloroglucinol 1,2-naphthoquinonediazido-5-sulfonate | 89 |
| s | Isoamyl gallate 1,2-naphthoquinonediazido-5-sulfonate | 63 |

### (2) Preparation of Positive Photoresist Composition and Evaluation Thereof:

1.25 g (as total weight of photosensitive substances) of one of Photosensitive Substances (n) to (s) obtained in the above mentioned section (1) and one of Photosensitive Substances (a), (b), (c), (f), (g) and (A) as produced in the above mentioned examples and 5.0 g of one of cresol-novolak resins as obtained in the above mentioned sections (8) and (9) were dissolved in 15 g of ethyl cellosolve acetate, as indicated 1n Table 5 below. The resulting blend was filtered through a 0.2 µm microfilter, and the photoresist composition thus obtained was coated on a silicon wafer with a spinner. This was then dried in a convection oven having a nitrogen atmosphere, at 90°C for 30 minutes to form a resist film having a thickness of 1.2 µm on the wafer. Next, the film was exposed by the use of a reduction projection exposure device (FPA-1550, manufactured by Canon) through a test chart mask, then developed with an aqueous 2.38% tetramethylammonium hydroxide solution for 1 minute, and thereafter rinsed with water for 30 seconds and dried.

The resist pattern thus formed on the silicon wafer was evaluated in the same manner as in the above mentioned section (10). The results obtained are shown in Table 5 below.

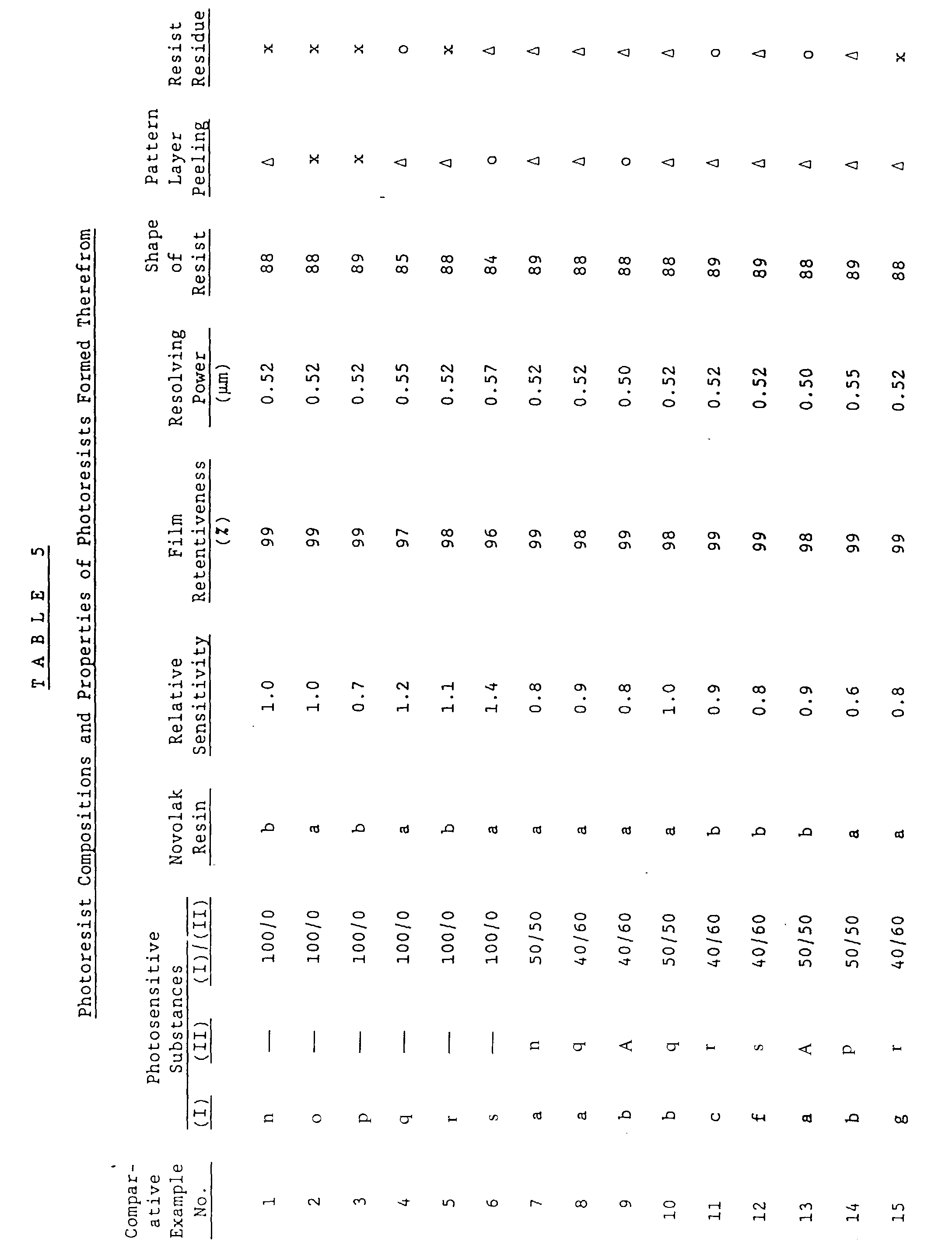

As is clearly demonstrated by the results obtained in these examples and comparative examples, the positive photoresist compositions of the present invention were all superior to the comparative compositions in that the former were free from development failures of "pattern layer peeling" and "resist residue" and additionally the former had a higher resolving power, a better cross sectional shape of the resist image to be obtained therefrom and a higher sensitivity.

The resist compositions of the present invention are highly stable during storage in the form of solutions thereof. In fact, solutions of resist compositions of the present invention did not form any precipitate after being stored for 30 days at 40°C, while those of comparative resist compositions of Comparative Examples 1, 2, 3, 5, 7, 11, 14 and 15 formed precipitates.

While the invention has been described in detail and with reference to specific embodiments thereof, it will be apparent to one skilled in the art that various changes and modifications can be made therein without departing from the spirit and scope thereof.
In formula (I), the halogen groups may be fluoro, chloro, bromo and iodo. Alkyl and alkoxy groups preferably contain 1 to 12, more preferably 1 to 6 carbon atoms. Alkenyl groups preferably contain 2 to 12, more preferably 2 to 8 carbon atoms. Cycloalkyl groups preferably contain 3 to 8 carbon atoms. Aryl groups preferably contain 6 to 20 carbon atoms, with phenyl, naphthyl and anthryl being particularly preferrred.

## Claims

1. A positive photoresist composition, which comprises:
(A) an alkali-soluble resin;
(B) (a) 1,2-naphthoquinonediazido-5-sulfonate(s) of an aromatic hydroxy compound selected from compounds of formula (I): 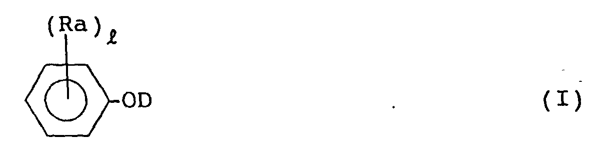 wherein Ra represents hydrogen, a halogen, a cyano group, a cycloalkyl group, an alkyl group, an alkoxy group, an aryl group or an alkenyl group; D represents a 1,2-naphthoquinonediazido-5-sulfonyl group; and 1 represents an integer of from 1 to 5; and
(C) (a) 1,2-naphthoquinonediazido-5-sulfonate(s) of an aromatic polyhydroxy compound having four to six hydroxyl groups in one molecule;
wherein the ratio of (B)/(C) is from 5/95 to 35/65.

2. A positive photoresist composition as in claim 1, wherein the polyfunctional photosensitive substance (C) is selected from
1,2-naphthoquinonediazido-5-sulfonates of polyhydroxybenzophenones,
bis((poly)hydroxyphenyl)alkanes,
polyhydroxybiphenyls, bis(polyhydroxy)sulfides,
bis(polyhydroxyphenyl)ethers,
bis(polyhydroxyphenyl)sulfoxides,
bis(polyhydroxyphenyl)sulfones,
polyhydroxytriphenylmethanes,
polyhydroxyspirobi-indanes,
polyhydroxyphthalides, polyhydroxybenzopyranes,
(polyhydroxy)benzoylpyridines, (polyhydroxy)indanes and flavonoid dyes.

3. A positive photoresist composition as in any one of claims 1 to 2, wherein the ratio of (B)/(C) is from 10/90 to 30/70.

4. A positive photoresist composition as in any one of claims 1 to 3, wherein the alkali-soluble resin (A) is a novolak resin.

5. A positive photoresist composition as in any one of claims 1 to 4, wherein the content of the mixture of the photosensitive substances is from 5 to 100 parts by weight per 100 parts by weight of the alkali-soluble resin.

6. A positive photoresist composition as in any one of claims 1 to 5, wherein the content of the mixture of the photosensitive substances is from 10 to 50 parts by weight per 100 parts by weight of the alkali-soluble resin.

7. A positive photoresist composition as in claim 4, wherein the molecular weight of the novolak resin is from 6,000 to 20,000.

## Patentansprüche

1. Positive Photoresist-Zusammensetzung, die umfaßt:
(A) ein Alkali-lösliches Harz;
(B) (a) 1,2-Naphthochinondiazido-5-sulfonat(e) einer aromatischen Hydroxyverbindung, die ausgewählt ist aus Verbindungen der Formel (I): 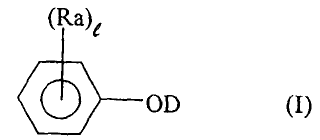 worin Ra Wasserstoff, ein Halogen, eine Cyangruppe, eine Cycloalkylgruppe, eine Alkylgruppe, eine Alkoxygruppe, eine Arylgruppe oder eine Alkenylgruppe ist; D eine 1,2-Naphthochinondiazido-5-sulfonylgruppe ist; und ℓ eine ganze Zahl von 1 bis 5 ist; und
(C) (a) 1,2-Naphthochinondiazido-5-sulfonat(e) einer aromatischen Polyhydroxy-Verbindung mit 4 bis 6 Hydroxygruppen in einem Molekül;
worin das Verhältnis von (B)/(C) von 5/95 bis 35/65 ist.

2. Positive Photoresist-Zusammensetzung nach Anspruch 1, worin die polyfunktionelle lichtempfindliche Substanz (C) ausgewählt ist aus
1,2-Naphthochinondiazido-5-sulfonaten von Polyhydroxybenzophenonen, Bis((poly)hydroxyphenyl)alkanen,
Polyhydroxybiphenylen, Bis(polyhydroxy)sulfiden,
Bis(polyhydroxyphenyl)ethern,
Bis(polyhydroxyphenyl)sulfoxiden,
Bis(polyhydroxyphenyl)sulfonen,
Polyhydroxytriphenylmethanen,
Polyhydroxyspirobi-indanen,
Polyhydroxyphthaliden, Polyhydroxybenzopyranen,
(Polyhydroxy)benzoylpyridinen, (Polyhydroxy)indanen und Flavonoid-Farbstoffen.

3. Positive Photoresist-Zusammensetzung nach irgendeinem der Ansprüche 1 bis 2, worin das Verhältnis von (B)/(C) von 10/90 bis 30/70 ist.

4. Positive Photoresist-Zusammensetzung nach irgendeinem der Ansprüche 1 bis 3, worin das Alkali-lösliche Harz (A) ein Novolak-Harz ist.

5. Positive Photoresist-Zusammensetzung nach irgendeinem der Ansprüche 1 bis 4, worin der Gehalt der Mischung an lichtempfindlichen Substanzen von 5 bis 100 Gew.-Teile pro 100 Gew.-Teile des Alkali-löslichen Harzes beträgt.

6. Positive Photoresist-Zusammensetzung nach irgendeinem der Ansprüche 1 bis 5, worin der Gehalt der Mischung an lichtempfindlichen Substanzen von 10 bis 50 Gew.-Teile pro 100 Gew.-Teile des Alkali-löslichen Harzes beträgt.

7. Positive Photoresist-Zusammensetzung nach Anspruch 4, worin das Molekulargewicht des Novolak-Harzes 6000 bis 20.000 beträgt.

## Revendications

1. Composition de photorésist positif qui comprend :
(A) une résine soluble en milieu alcalin ;
(B) (a) un ou des 1,2-naphtoquinonediazido-5-sulfonates d'un composé hydroxylé aromatique choisi parmi les composés de formule (I): 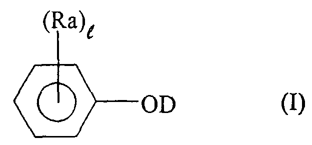 où Ra représente l'hydrogène, un halogène, un groupe cyano, un groupe cycloalkyle, un groupe alkyle, un groupe alcoxy, un groupe aryle ou un groupe alcényle ; D représente un groupe 1,2-naphtoquinonediazido-5-sulfonyle et ℓ représente un entier de 1 à 5 ; et
(C) (a) un ou des 1,2-naphtoquinonediazido-5-sulfonates d'un composé polyhydroxylé aromatique ayant 4 à 6 groupes hydroxyles dans une molécule ; où le rapport (B)/(C) est de 5/95 à 35/65.

2. Composition de photorésist positif selon la revendication 1 où la substance photosensible polyfonctionnelle (C) est choisie parmi
les 1,2-naphtoquinonediazido-5-sulfonates de polyhydroxybenzophénones,
les bis((poly)hydroxyphényl)alcanes,
les polyhydroxybiphényles, les bis(polyhydroxy)sulfures,
les bis(polyhydroxyphényl)éthers,
les bis(polyhydroxyphényl)sulfoxydes,
les bis(polyhydroxyphényl)sulfones,
les polyhydroxytriphénylméthanes,
les polyhydroxyspirobi-indanes,
les polyhydroxyphtalides, les polyhydroxybenzopyranes,
les (polyhydroxy)benzoylpyridines, les (polyhydroxy)indanes et les colorants flavonoïdes.

3. Composition de photorésist positif selon l'une quelconque des revendications 1 à 2 où le rapport (B)/(C) est de 10/90 à 30/70.

4. Composition de photorésist positif selon l'une quelconque des revendications 1 à 3 où la résine soluble en milieu alcalin (A) est une résine novolaque.

5. Composition de photorésist positif selon l'une quelconque des revendications 1 à 4 où la teneur du mélange des substances photosensibles est de 5 à 100 parties en masse pour 100 parties en masse de la résine soluble en milieu alcalin.

6. Composition de photorésist positif selon l'une quelconque des revendications 1 à 5 où la teneur du mélange des substances photosensibles est de 10 à 50 parties en masse pour 100 parties en masse de la résine soluble en milieu alcalin.

7. Composition de photorésist positif selon la revendication 4 où la masse moléculaire de la résine novolaque est de 6 000 à 20 000.
